(19) Europäisches Patentamt
European Patent Office
Office européen des brevets

(11) EP 1 705 213 B1

(12) **EUROPEAN PATENT SPECIFICATION**

(45) Date of publication and mention of the grant of the patent:
**08.04.2009 Bulletin 2009/15**

(51) Int Cl.:
***C08K 3/22*** *(2006.01)* ***C08K 13/06*** *(2006.01)*
***C08K 9/00*** *(2006.01)* ***C08L 25/06*** *(2006.01)*
***C08L 55/02*** *(2006.01)* ***C08L 51/04*** *(2006.01)*

(21) Application number: **05016266.8**

(22) Date of filing: **27.07.2005**

(54) **Flame-retardant resin composition and flame-retardant resin molded item**

Flammhemmende Harzzusammensetzung und die damit hergestellten flammhemmenden Formkörper

Composition de résine ignifuge et objet moulé ignifuge

(84) Designated Contracting States:
**DE GB NL**

(30) Priority: **24.03.2005 JP 2005087301**

(43) Date of publication of application:
**27.09.2006 Bulletin 2006/39**

(73) Proprietor: **FUJI XEROX CO., LTD.**
**Minato-ku,**
**Tokyo (JP)**

(72) Inventors:
- **Okoshi, Masayuki**
  **Minamiashigara-shi**
  **Kanagawa (JP)**
- **Okazaki, Hitoshi**
  **Minamiashigara-shi**
  **Kanagawa (JP)**
- **Hoshio, Takuro**
  **Minamiashigara-shi**
  **Kanagawa (JP)**
- **Yasuno, Michiaki**
  **Minamiashigara-shi**
  **Kanagawa (JP)**
- **Tanaka, Toshihide**
  **Ebina-shi**
  **Kanagawa (JP)**
- **Nonaka, Tomoharu**
  **Ebina-shi**
  **Kanagawa (JP)**
- **Tsuyoshi, Miyamoto**
  **Minamiashigara-shi**
  **KANAGAWA (JP)**
- **Suzuki, Tomofumi**
  **Ebina-shi**
  **Kanagawa (JP)**

(74) Representative: **Fuhlendorf, Jörn**
**Dreiss Patentanwälte**
**Postfach 10 37 62**
**70032 Stuttgart (DE)**

(56) References cited:
**EP-A- 1 528 083**
**WO-A-20/04074361**
**DE-A1- 19 828 536**
**US-A- 4 983 663**
**US-A- 5 532 302**
**US-B1- 6 831 120**

Remarks:
The file contains technical information submitted after the application was filed and not included in this specification

EP 1 705 213 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

BACKGROUND OF THE INVENTION

Field of the Invention

The present invention relates to a flame-retardant resin composition in which flame-retardant particles are mixed into the resin, and a flame-retardant resin molded item, and more specifically, is to be used in cabinets for household appliances and OA products, wires, cables, automotive vehicles, ships, airplanes, railroad cars, building materials, electronic equipment, printed circuit boards, and the like, for the purpose of protecting them against hazard due to heat, such as that of fire or the like.

Description of the Related Art

As flame retardants to be mixed into a resin (matrix resin) and used for the purpose of flame retarding, halogen-based compounds, antimony trioxide, phosphorous-based compounds, hydrated metallic compounds (metal hydrates), and the like have conventionally been used. However, the above-mentioned halogen-based compounds and antimony trioxide are being avoided due to environmental problems, while the hydrated metallic compounds not only reduce environmental burden, but are also excellent from the viewpoint of resin recycling, thus being preferable.
However, as compared to organic flame retarding compounds, hydrated metallic compounds require that a large amount thereof be compounded, in order to obtain an equivalent flame retardancy, which results in the physical properties of the polymer being substantially degraded. In order to achieve flame retardancy equivalent to that of organic flame retarding compounds without degrading the physical properties of the polymer, a hydrated metallic compound of a small particle diameter must be uniformly dispersed and stabilized as particles in the matrix resin without aggregation being caused. Therefore, when the particles consisting of the hydrated metallic compound are to be mixed into the resin, it is preferable to form a uniform coated layer on the surface of the particles, in order to assure the dispersibility thereof in the matrix resin, and to prevent active groups from affecting the matrix resin to impair the resin properties.
As methods for forming a coated layer on the surface of the particles, a surface treatment formation method using a higher fatty acid or the like, a silica layer formation method, and the like are known through Japanese Patent Application Laid-Open(JP-A) Nos. 52-30262/ 1977, 2003-253266, and the like. However, when such a method is applied to nano-size particles, it is difficult for the particles to be sufficiently dispersed under conventional reaction conditions, and the coating reaction rate is rapid, whereby the particles undergo the coating reaction in aggregated state, and thus uniformly coated particles cannot be obtained.
In addition, methods of treating the surfaces of inorganic powder particles with a polyamino acid, and of causing cyclic organosiloxane in the gas phase to act on the inorganic powder particle surfaces are disclosed in JP-A Nos. 57-145006/1982 and 61-268763/1986. However, when these methods are applied to nano-size particles, the dispersibility is not assured, which leads to occurrence of aggregates.
In addition, a flame retardant polyolefin composition wherein a compound metal hydroxide (a flame retardant) and a silicone compound (an auxiliary flame retardant) are blended with polyolefin is proposed by JP-A No. 10-245456/ 1998 and the like. However, the flame retardant is of a large particle diameter, and the composite provides a mere blend, whereby the synergistic effect of the flame retardant and the auxiliary flame retardant is not sufficiently obtained.
Further, as a flame retardant resin composition of low environmental burden that generates no harmful gasses upon combustion, a resin composition in which a flame retardant resin consisting of a graft copolymer obtained by graft polymerizing a vinyl monomer onto polyorganosiloxane particles having an average particle diameter of 0.008 to 0.2 $\mu$m is compounded into a thermoplastic resin, and as a resin composition which has a flame retardancy comparable to that of vinyl chloride resin and generates no harmful gases upon incineration processing, a non-halogen-based flame retardant resin composition in which magnesium hydroxide, zinc borate, and silicone powder are added to a polyolefin resin are proposed in JP-A Nos. 2000-264935, 2000-191844, and the like.
However, these flame-retardant resin compositions present problems in that, with the former, even if it is applied to engineering plastics, the flame retarding due to the siloxane particles alone cannot provide a sufficient flame retardancy, and with the latter, a large quantity of magnesium hydroxide (100 phr or more) is compounded, and thus if it is applied to engineering plastics, such as an ABS and the like, a sufficient strength cannot be obtained.
Further, in recent years, as examples of resin flame retarding using fire particles, a polymer nano-composite composition of a polyamide and a treated silicate, and a polycarbonate blend containing a graft polymer, phosphonate amine and inorganic nano particles have been proposed in Japanese Patent Application National Publication Nos. 2003-517488 and 2003-509523. However, when either of these is used as a flame retardant, the problems as mentioned above still occur.
In EP-A 152 80 83, a flame retardant resin composition comprising a matrix resin and granular flame-retardant

fine particles blended therein having a volume average particle diameter in a range of about 1 to 500 nm, is described. The granular flame retardant fine particles comprise inorganic fine particles and an organic compound on the surface thereof and may further comprise hydrated metal compounds having a particle diameter in a range of about 0.5 to about 50 $\mu$m.

US 6,831,120 describes the use of a combination of phosphonate amines and very finely divided inorganic powder, having an average particle diameter smaller than or equal to 200 nm, with a markedly improved flame retardancy compared to a thermoplastic moulding composition without the addition of the finely divided inorganic powder.

In DE-A 198 28 536, the combined addition of phosphazenes and inorganic nano-sized particles is described to be of an excellent flame retardancy together with further good mechanical properties.

The use of metal hydroxides as flame retardant additives to polymers is further described in WO-A 2004/074361, US 5,532,302 or US 4,983,663, but without the metal hydroxide particles being within the nano-range.

In addition, the flame retardant particles of the hydrated metallic compounds and the like, which have conventionally been used as a flame retardant, present a problem in that they must be compounded in a large quantity, as compared to the organic flame retardant compounds, in order to obtain an equivalent flame retardancy, and compounding such a large quantity of particles degrades the physical properties, the electrical properties, and the like of the resin.

In other words, as features of a flame-retardant resin composition and a flame-retardant resin molded item, it is eagerly demanded that degradation of mechanical physical properties is low, and environmental burden is small; specifically, that a high flame retardancy is obtained with no harmful gases being generated, and the polymer physical properties are not substantially degraded; and further that recyclability is excellent.

## SUMMARY OF THE INVENTION

The present invention has been made in view of the above circumstances and provides a flame-retardant resin composition and a flame-retardant resin molded item according to the features of claim 1 and claim 7, respectively.

## DETAILED DESCRIPTION OF THE INVENTION

Hereinbelow, the present invention is described in detail.

### <Flame-retardant resin composition>

The flame-retardant resin composition of the present invention is characterized in that at least flame-retardant particles comprising a metal hydrate and having a volume-average particle diameter in the range of 1 to 500 nm and an auxiliary flame retardant are compounded in a matrix resin.

As described above, the flame-retardant particles of a hydrated metallic compound or the like, which have conventionally been used as a flame retardant, must be compounded in a large amount into the matrix resin, compared to the organic flame retardant compounds, in order to obtain an equivalent flame retardancy, which results in the physical properties of the polymer being substantially degraded. Therefore, to prevent the degradation of the physical properties of the polymer, the amount of the flame retardant to be added must be reduced.

The above-mentioned "flame retardant" compound refers to a compound which, when 5 parts by mass thereof is contained in an ABS resin and/or a polystyrene, exhibits a maximum heat generation rate, as defined in ISO 5660, that is no more than one third of that before the flame-retardant compound is contained.

As one of the methods for the addition amount reduction, by further atomizing the flame-retardant particles down to nano size for increasing the specific surface area of the particles, and as a result of this, increasing the contact area with the polymer, even addition of a small amount can provide flame retarding capability which is comparable with that of the conventional halogen-based flame retardants.

The hydrated metallic compound which is used as the flame retardant provides two different effects, i.e., the effect of reducing the quantity of heat by releasing water through thermal decomposition upon combustion, and the effect of diluting the combustion gas generated from the polymer upon combustion. Further, it is known that these effects cannot generally be provided to a sufficient degree if the flame retardant is not added in a large amount. However, such a phenomenon is only a phenomenon which occurs with a conventional hydrated metallic compound having a micro size particle diameter.

The inventors have found that, by reducing the particle diameter of the flame retardant down to nano size, the effect of lowering the quantity of heat and the effect of diluting the combustion gas generated from the polymer upon combustion can be made more precise and greater. The difference in the effect between the particle diameter of micro size and that of nano size is self-evident, when it is considered, for example, whether it is more dffective to use a watering pot to extinguish the fire of a combustible or to use an atomizer which can blow fine drops of water against the fire source.

On the other hand, in rendering a polymer flame-retardant by adding a flame retardant, more than one flame

retardant is used in combination in almost all cases, and of the flame retardants used, that which is compounded into the resin in the largest amount is the main flame retardant, and that which is added in a small amount in order to further enhance the flame retarding effect of the main flame retardant is an auxiliary flame retardant.

For example, an antimony oxide compound serves as an auxiliary flame retardant to a bromine-based flame retardant, the antimony oxide compound, which is reactive with bromine upon combustion, further enhancing the flame retarding capability of the bromine-based flame retardant, which is the main flame retardant. It is presumed that, in this case, the auxiliary flame retardant reacts with the bromine-based flame retardant, having an endothermal effect, and thus the auxiliary flame retardant is used in combination with the flame retardant for obtaining a further synergetic effect.

On the other hand, some auxiliary flame retardants provide two different effects, i.e., the effect of being actively carbonized to cover the surface of the polymer upon combustion for blocking out oxygen, and the effect of blocking out the combustibles generated from the polymer. Such a compound is called a char-forming compound, and the flame retarding effect thereof differs from that which the hydrated metallic compound has.

In the present invention, it has been found that, by combining the two different types of effects of the hydrated metallic compound and the char-forming compound (the auxiliary flame retardant), a further improvement of the flame retarding effect is achieved.

Specifically, it has been found that, when a hydrated metallic compound and a char-forming compound are used in combination, the superiority obtained by nano-sizing the hydrated metallic compound is combined with the effect which the char-forming compound originally has, and thus it is possible to provide a further improvement of the flame retardancy, compared to the combined effect of the conventional micro-size hydrated metallic compound with the char-forming compound. The reason for this is considered to be that, because the hydrated metallic compound is of nano size, the distance between it and the char-forming compound in the polymer is extremely short.

Further, In the present invention, it has been found that, by using a nano-sized hydrated metallic compound as the flame retardant and an auxiliary flame retardant which can form a char, a flame-retardant resin composition which does not generate any harmful gases upon combustion and imposes only a small burden on the environment upon recycling can be obtained due to the compound effect of these two components as described above.

Hereinbelow, the constitution and the like of the flame-retardant resin composition of the present invention is described.

<Flame-retardant particles>

In the present invention, the flame-retardant particles comprise a metal hydrate and have a volume-average particle diameter in the range of 1 nm to 500 nm. In addition, the volume-average particle diameter of the flame retardant particles is preferably in the range of 1 to 200 nm, is more preferably in the range of 5 to 200 nm, and is still more preferably in the range of 10 to 200 nm (particularly in the range of 10 to 100 nm).

When the volume-average particle diameter of the flame retardant particles is under 1 nm, the flame retardancy holding capability is lowered. In addition, when it is over 500 nm, the properties are equivalent to those of the commercially available flame retardant particles which volume-average particle diameter is 1 μm, which require a large amount of addition in order to obtain a desired flame retardancy.

In addition, the flame retardant particles having a volume-average particle diameter in the above range are uniformly dispersed in the resin. Further, when the volume-average particle diameter of the flame retardant particles is of nanometer size, a fine composite material can be formed, and a flame-retardant resin composition with a high transparency can be obtained.

As the metal hydrate, a metal hydrate of one type of metal selected from, for example, Mg, Ca, A1, Fe, Zn, Ba, Cu, and Ni can be used. The metal hydrates of these metals are easy to be atomized, and are not only stable as a hydrate, but also excellent in endothermic ability and dehydration reactivity when heated, thus providing an excellent flame retarding effect. Among the hydrated compounds of the above-mentioned metals, the hydrates of Mg, A1, and Ca are particularly preferable.

The hydrate of a metal is not particularly limited as far as it is provided that it holds a flame retarding component. However, specifically, a metal hydrate, such as aluminum hydroxide, magnesium hydroxide, calcium hydroxide, iron hydroxide, zinc hydroxide, copper hydroxide, nickel hydroxide, or the like; that which consists of a hydrate, such as calcium aluminate, dihydrated gypsum, zinc borate, barium metaborate, or the like; and the like are exemplified. Among these, magnesium hydroxide, aluminum hydroxide, and calcium hydroxide are preferable.

In addition, a hydrate of a composite metal, comprising Mg and at least one type of metal selected from Ca, A1, Fe, Zn, Ba, Cu, and Ni, can be used. Thus, by using Mg as essential metal and compositing various metals with Mg, the flame retarding effect can be improved. For example, when Mg and Ni or Fe are composited, the hydrogen in the hydrocarbon that is derived from the resin component vaporized in the combustion can be extracted for enhancing the flame retarding effect and the effect of reducing the amount of smoke emission. In the other hand, by compositing Mg and A1, water release temperature in the combustion can be adjusted for improvement of the flame retarding effect.

In the present invention, when a hydrate of a composite metal comprising Mg and at least one type of metal selected from Ca, Al, Fe, Zn, Ba, Cu, and Ni is used as the flame retardant particles, the hydrate of the compound metal is represented by the following formula (1):

Formula (1): $MgM_x \bullet (OH)_y$

In the above formula, M denotes at least one type of metal selected from Ca, Al, Fe, Zn, Ba, Cu, and Ni, x denotes a positive real number of 0.1 to 10, and y an integer of 2 to 32.
As the M, it is preferable to use Ca, A1, Fe, Zn, Ba, Cu, or Ni. In particularly, $MgM_x$, is preferably $MgAl_x$, $MgCa_x$, $MgZn_x$, $MgFe_x$, or $Mg(Al \bullet Ca)_x$.
For the flame retardant particles in the present invention, in order to improve the dispersibility of the flame retardant particles of nano size in the matrix resin, it is preferable to form a uniform coated layer on the surface of the flame retardant particles (hereafter, these flame retardant particles may be called the surface-coated flame retardant particles). If a coated layer is formed, the flame retarding component can be stably held in the metal hydrate particles, and the affinity to the matrix resin can be greatly improved. In addition, the coated layer preferably comprises an organic compound or a polysilicone.
The organic compound is not particularly limited, but it preferably possesses an organic group which is bindable to the flame retardant particles. By binding such an organic group to the flame retardant particles, a thin organic layer can be formed on the surface of the flame retardant particles.
As the organic compound, that which has a binding group for forming a bond to a flame retardant particle at the end of the organic group is preferable.
Examples of the above-mentioned binding group include the hydroxyl group, the phosphate group, the phosphonium group, the amino group, the sulfate group, the sulfonate group, the carboxylic group, the hydrophilic heterocycle group, the polysaccharide group (such as sorbitol, sorbit, saccharose ester, sorbitan ester residue, or the like), the polyether group (the polyoxyalkylene group having 2 to 4 alkylene carbon atoms, such as the polyoxyethylene group, the polyoxypropylene group, or the like.), the hydrolyzable group (the alkoxy group having 1 to 4 carbon atoms, such as the methoxy group, the ethoxy group, the propoxy group, the isopropoxy group, the butoxy group, or the like.), the halogen atom (such as the bromine, the chlorine atom, or the like), and the like.
When the binding group is an anionic group (such as the sulfate group, the sulfonate group, the carboxylic group, or the like), it may form a salt with various bases. Examples of the base include inorganic bases (such as the alkaline earth metals, such as calcium, magnesium, and the like; the alkaline metals, such as sodium, potassium, and the like; ammonia, and the like), organic bases (such as amines and the like). When the binding group is an cationic group (such as the amino group or the like), it may form a salt with an acid, such as an inorganic acid (such as hydrochloric acid, sulfuric acid, or the like), or an organic acid (such as acetic acid or the like). Further, the above-mentioned cationic group may form a salt with an anionic group (particularly, the carboxylic group, or the sulfate group). In addition, the organic compound may have both a cationic group and an anionic group as the binding groups.
Thus, the preferable binding groups include the ionic groups (the anionic group and/or the cationic group), and the hydrolyzable group, and the bond formed with a flame retardant particle may be an ionic bond or a covalent bond.
Examples of the organic group in the organic compound include a group which functions as the hydrophobic group of a surfactant or the like (such as a higher fatty acid residue, a higher alcohol residue, an alkyl-aryl group, or the like), a polyamino acid residue, and the like.
Examples of the above-mentioned higher fatty acid include a saturated fatty acid having 8 to 30 carbon atoms (preferably, a saturated fatty acid having 10 to 28 carbon atoms, and more preferably, a saturated fatty acid having 12 to 26 carbon atoms), such as lauric acid, myristic acid, palmitic acid, arachic acid, behenic acid, lignoceric acid, cerotic acid, caprylic acid, capric acid, daturic acid, stearic acid, montanoic acid, melissic acid, or the like; an unsaturated fatty acid having 12 to 30 carbon atoms (preferably, an unsaturated fatty acid having 14 to 28 carbon atoms, and more preferably, an unsaturated fatty acid having 14 to 26 carbon atoms), such as elaidic acid, linoleic acid, linolenic acid, lindelic acid, oleic acid, gadoleic acid, erucic acid, brassidic acid, or the like.
Examples of the hydrophobic group include these higher fatty acid residues or the higher alcohol residues corresponding to the higher fatty acids (such as higher fatty acid residues having 8 to 24 carbon atoms (preferably, higher fatty acid residues having 10 to 22 carbon atoms, and more preferably, higher fatty acid residues having 12 to 20 carbon atoms), such as octyl, nonyl, dodecyl, tetradodecyl, hexadecyl (cetyl), octadecyl, and the like), and the like.
In addition, examples of the alkyl-aryl group include an alkyl-aryl group, such as hexylphenyl, octylphenyl, nonylphenyl, decylphenyl, dodecylphenyl, isopropylphenyl, butylphenyl, amylphenyl, tetradecylphenyl, or the like (preferably, an alkyl (having 1 to 20 carbon atoms)-aryl (having 6 to 18 carbon atoms) group, more preferably, an alkyl (having 6 to 18 carbon atoms)-aryl (having 6 to 12 carbon atoms) group, and particularly, an alkyl (having 6 to 16 carbon atoms)-phenyl group), and the like.
These hydrophobic groups may be substituted by various substituents (such as an alkyl group having 1 to 4

carbon atoms and the like).

In addition, the polysilicone is not particularly limited as far as it has a siloxane bond, but it is preferable that a polymer of a cyclic organosiloxane compound as represented by the following formula (2) be used.

Formula (2)

(a)

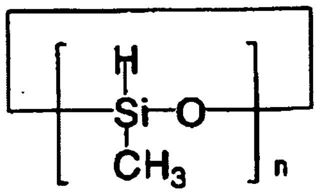

(b)

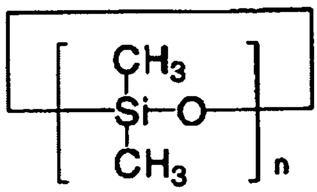

In the above formula, n denotes an integer of 3 to 8. The smaller the value of the n, the lower the boiling point of the polysilicone and the larger the amount of the polysilicone evaporated and adsorbed by the flame retardant particles, while when the value of the n exceeds 7, it is difficult for polysilicone to be evaporated. As a result, it is not preferable in the view point of insufficient coating treatment. In addition, particularly the tetramer, pentamer, and hexamer are easy to be polymerized, being the most appropriate.

In the present invention, either one of the cyclic organosiloxane compounds (a) and (b) represented by the formula (2) or a combination of these two may be used. The degree of polymerization (the number of units repeated) is preferably in the range of 10 to 1000, and is more preferably in the range of 10 to 100. In addition, as the coated layer, the above-mentioned polymer may be used in combination with the organic compound.

As the coated layer, by using polysilicone having the low-surface energy as mentioned above, plasticization of the resin is made difficult to occur when the surface-coated flame retardant particles are mixed with the matrix resin.

In addition, with the flame-retardant resin composition produced, the surface silicone layer forms a thermal barrier layer in combustion. By forming a polysilicone coated layer on the particle surface, the moisture released from the metal hydrate causes the thermal barrier layer to be foamed, which allows the thermal insulating properties of the thermal barrier layer to be enhanced, and the flame retarding effect to be improved.

In the present invention, the amount of surface coating by an organic compound in the surface-coated flame retardant particles is preferably in the range of 1 to 200 percent by mass of the whole surface-coated flame retardant particles, is more preferably in the range of 20 to 100 percent by mass, and is still more preferably in the range of 30 to 80 percent by mass when the amount of surface coating is under 1 percent by mass, aggregates may be generated in the matrix resin, resulting in the dispersion being non-uniform. In the other hand, when the amount of surface coating exceeds 200 percent by mass, the resin may be plasticized when the surface-coated flame retardant particles are dispersed into the matrix resin.

In addition, the amount of surface coating by the polysilicone in the surface-coated flame retardant particles is preferably in the range of 20 to 200 percent by mass of the whole surface-coated flame retardant particles, and is more preferably in the range of 20 to 80 percent by mass when the amount of surface coating is under 20 percent by mass, aggregates may be generated in the matrix resin, resulting in the dispersion being non-uniform. In the other hand, when the amount of surface coating exceeds 200 percent by mass, the resin may be plasticized when the surface-coated flame retardant particles are dispersed into the matrix resin.

The uniformity of the coated layer can be verified by observing the surface-coated flame retardant particles with a transmission electron microscope.

Also for the surface-coated flame retardant particles in the present invention, the volume-average particle

diameter (when the surface-coated flame retardant particles are non-spherical, the average diameter of the circumscribed circle) is the same as described previously.

In addition, the degree of dispersion of the flame retardant particles in the present invention is preferably in the range of 0.1 to 3.0, is more preferably in the range of 0.1 to 1.0, and is particularly preferably in the range of 0.1 to 0.8.

The degree of dispersion being low means that the particle size distribution for the flame retardant particles is narrow, i.e., that the size of the particles is more uniform, and in the case where the degree of dispersion is in the range, the flame retardancy and the mechanical properties are uniform when the flame retardant particles are dispersed into the resin.

The volume-average particle diameter, and degree of dispersion are measured by using the laser doppler heterodyne type particle size distribution meter (MICROTRAC-UPA150, manufactured by UPA NIKKISO Co., Ltd.) (the same applies hereinbelow). Specifically, on the basis of the measured particle size distribution, a cumulative distribution curve is drawn for volume from the side of the smaller particle diameter, and the particle diameter providing 50% cumulative is defined to be the volume-average particle diameter. In addition, a cumulative distribution curve is drawn for mass, and when the particle diameter providing 90% cumulative from the smaller particle diameter is defined as $D_{90}$, and the particle diameter providing 10% cumulative is defined as $D_{10}$, the degree of dispersion is defined by the following formula (3). For this same measuring method, the same applies hereinbelow.

$$\text{Formula (3):} \quad \text{Degree of dispersion} = \log(D_{90}/D_{10})$$

The method for manufacturing of the surface-coated flame retardant particles is not particularly not limited as far as it can suit the above-mentioned constitution and properties, but preferable examples include the method which disperses metal hydrate particles into an aqueous solution in which an organic compound metallic salt and a dispersing agent are dissolved, and forms an organic compound layer on the surface thereof; the method which causes a vaporized organic siloxane to act upon the surface of the metal hydrate particles for formation of a polysilicone compound layer; further the method which spreads a metallic alkylate into an organic solvent for formation of a reverse micelle, and rendering the metallic ions to be a metal oxide for formation of surface-coated particles and the like.

he amount of compounding of the flame retardant particles in the flame-retardant resin composition of the present invention is preferably in the range of 0.1 to 80 parts by mass to 100 parts by mass of the matrix resin later described, and is more preferably in the range of 5 to 50 parts by mass.

<Auxiliary flame retardant>

The auxiliary flame retardant used with the present invention is preferably at least one type selected from, for example, boric acid-based auxiliary flame retardant, ammoniated auxiliary flame retardant, the other inorganic auxiliary flame retardants, nitrogen-based auxiliary flame retardant, the other organic auxiliary flame retardants, and colloid-based auxiliary flame retardant.

Examples of the boric acid-based auxiliary flame retardant include compounds containing boric acid, such as zinc borate hydrates, barium metaborate, borax, and the like.

Examples of the ammoniated auxiliary flame retardant include ammonia compounds, such as ammonium sulfate.

Examples of the other inorganic auxiliary flame retardants include iron oxide-based combustion catalysts, such as ferrocene; titanium-containing compounds, such as titanium oxide; guanidine-based compounds, such as guanidine sulfamate; further, zirconium-based compounds; molybdenum-based compounds; tin-based compounds; carbonate compounds, such as potassium carbonate; hydrated metallic compounds, such as aluminum hydroxide, magnesium hydroxide, and the like; and modifications thereof.

Examples of the nitrogen-based auxiliary flame retardant include cyanulate compounds having a triazine ring.

Examples of the other organic auxiliary flame retardants include chlorendic anhydride; phthalic anhydride; compounds containing bisphenol A; glycydil compounds, such as glycydil ether and the like; polyhydric alcohols, such as diethyleneglycol, pentaerythrytol, and the like; modified carbamides; silicone compounds, such as silicone oil, organosiloxane, and the like.

Examples of the colloid-based auxiliary flame retardant include colloids of hydrated metallic compounds, such as aluminum hydroxide, magnesium hydroxide, calcium hydroxide, and the like, which have conventionally been used, having a flame retardancy; a hydrate of calcium aluminate, dihydrated gypsum, zinc borate, barium metaborate, borax, kaolin clay, or the like; nitric acid compounds, such as sodium nitrate; molybdenum compounds; zirconium compounds; antimony compounds; and flame retardant compounds, such as dawsonite, prosopite and the like.

The above-mentioned respective auxiliary flame retardants may be used alone or in combination of two or

more with one another.

As the auxiliary flame retardant to be used with the present invention, it is preferable to use one or more types selected from boric acid-based auxiliary flame retardant, silicone compound, and nitrogen-based auxiliary flame retardant, since these auxiliary flame retardants provide an excellent flame retarding effect with a relatively small amount thereof and are not deteriorated by thermal history in recycling and the like.

The amount of compounding of the flame retardant particles in the flame-retardant resin composition of the present invention is preferably in the range of 0.1 to 50 parts by mass to 100 parts by mass of the matrix resin later described, and is more preferably in the range of 1 to 30 parts by mass.

The matrix resin in the flame-retardant resin composition of the present invention is not particularly limited as far as it is a macromolecular compound, such as rubber, plastics and the like, and specific examples include a biodegradative resin, an ABS resin, an ACS resin, an alkyd resin, an amino resin, an ASA resin, a bismaleimidetriazine resin, a chlorinated polyether, a chlorinated polyethylene, an allyl resin, an epoxy resin, an ethylene-propylene copolymer, an ethylene-vinyl acetate-vinyl chloride copolymer, an ethylene-vinyl chloride copolymer, an ethylene-vinyl acetate copolymerized resin, an FRP, an ionomer, a methacrylate ester-styrene copolymer, a nitrile resin, a polyester, an olefin vinyl alcohol copolymer, a petroleum resin, a phenolic resin, a polyacetal, a polyacrylate, a polyallylsulfone, a polybenzoimidazol, a polybutadiene, a polybutylene, a polybutyleneterephthalate, a polycarbonate (PC), a polyetheretherketone, a polyetherketone, a polyethernitrile, a polyethersulfone, a polyethylene, a polyethyleneterephthalate, a polyketone, a methacrylic resin, a polymethylpentene, a polypropylene, a polyphenyleneether (PPE), a polyphenylenesulfide, a polysulfone, a polystyrene (PS), an SAN resin, a butadiene-styrene resin, a polyurethane, a polyvinyl acetal, a polyvinyl alcohol, a polyvinyl chloride, a polyvinylidene chloride, a fluoro resin, a silicone resin, a polyvinyl acetate, a xylene resin, a thermoplastic elastomer, an EPDM, a CR, a BR, a nitrile rubber, a natural rubber, an acrylonitrile, a butadiene rubber, a fluoro rubber, a butyl rubber, and the like.

Among these, the ABS resin is preferable, because it is excellent in surface properties of the molded element after molding, and the polystyrene are preferable, because it is excellent in transparency of the molded element after molding. These can be used alone or in combination of two or more with one another.

Particularly, with the ABS resin, an ABS resin which are modified with a condensed polycyclic aromatic resin obtained by polycondensing a heavy oil, a phenol, a carbonate, or a pitch and a formaldehyde compound in the presence of an acid catalyst is excellent, because it has an added substance to form a char as mentioned above, and thus has an improved flame retardancy, and when used in combination with the flame retardant particles, it further provides a synergetic effect.

In addition, for example, a resin compound with which the above-mentioned ABS resin, the flame retardant particles, and the like are compounded may be polymer-blended with some other resin. As the some other resin, various engineering plastics, such as a polycarbonate, a polyphenyleneether, a polyamide, and the like, can be mentioned.

The flame-retardant resin composition of the present invention can be compounded with a stabilizer and the like which are generally compounded. These are not particularly limited. Preferable examples of them include a crosslinking agent, a crosslinking accelerator, an auxiliary crosslinking accelerator, an activator, a crosslinking inhibitor, an age resistor, an oxidation inhibitor, an ozone deterioration inhibitor, an ultraviolet absorber, a light stabilizer, a tackifier, a plasticizer, a softener, a reinforcing agent, a strengthening agent, a foaming agent, an auxiliary foaming agent, a stabilizer, a lubricant, a mold releasing agent, an antistatic agent, a denaturing agent, a coloring agent, a coupling agent, a preservative, a fungicide, a modifier, a binding agent, a reodorant, a polymerization catalyst, a polymerization initiator, a polymerization inhibitor, a polymerization retarder, a polymerization regulator, a crystal core agent, a compatibilizing agent, a dispersing agent, a deforming agent, and the like.

These can be used alone or in combination of two or more with one another.

With the flame-retardant resin composition of the present invention, by using not only the flame retardant particles, and auxiliary flame retardant, but also a flame retardant having a greater particle diameter in combination, the smaller flame retardant particles fill the interspaces between greater particles in the polymer matrix, therefore stone-wall-like effect is obtained, and thus an effect of the flame retarding substances being distributed in the matrix resin with no interspaces is obtained. And, this effect further improves the flame retardancy.

The volume-average particle diameter of the flame retardant is preferably from 0.5 $\mu$m to 50 $\mu$m, and more preferably from 0.5 $\mu$m to 30 $\mu$m. When the volume-average particle diameter is under 0.5 $\mu$m, the stone-wall-like structure may not be obtained because of too small the particles. When the volume-average particle diameter is over 0.5 $\mu$m, the mechanical properties of the polymer may be degraded.

The flame retardant is particularly not limited, but it is preferable to use one or more types selected from hydrated metallic compound, inorganic hydrate, nitrogen-containing compound, and silicon-containing inorganic filler.

The hydrated metallic compound is preferably any one selected from aluminum hydroxide, magnesium hydroxide, and calcium hydroxide. The inorganic hydrate is preferably any one selected from calcium aluminate, dihydrated gypsum, zinc borate, barium metaborate, borax, and kaolin clay. In addition, the nitrogen-containing compound is preferably sodium nitrate. Further, the silicon-containing inorganic filler is preferably any one selected from the molybdenum

compounds, the zirconium compounds, the antimony compounds, dawsonite, prosopite, smectite, and the like.

The above-mentioned flame retardants may be used alone or in combination of two or more with one another. In addition, the above-mentioned selected flame retardant compound may be the same as or different from the compound constituting the inorganic fine particles used for the flame retardant particles.

The content of the flame retardant is preferably in the range of 0.1 to 200 parts by mass to 100 parts by mass of the flame retardant particles, and is more preferably in the range of 0.1 to 50 parts by mass. When the content is under 0.1 parts by mass, the stone-wall-like structure may not be obtained because of too low the content. When the content is over 200 parts by mass, the mechanical properties of the polymer may be degraded due to too high the amount of the flame retardant.

With the flame-retardant resin composition of the present invention, by using not only the flame retardant particles, and auxiliary flame retardant, but also a smectite subjected to an organic treatment in combination, in the matrix resin, the interspaces between smectite particles having a large aspect ratio are filled with the small flame retardant particles. Therefore a point-and-line-like effect is obtained, and thus an effect of the flame retarding substances being distributed in the matrix resin with no interspaces is obtained.

Further, when the organic-treated smectite is dispersed into the resin, that resin becomes transparent, and the flame retardant particles in the present invention have a size smaller than the wavelength of the visible light, and are uniformly dispersed in the resin, thus the combination compounded resin is excellent in transparency.

The flame-retardant resin composition of the present invention can be obtained by mixing the above-mentioned flame retardant particles, auxiliary flame retardant, matrix resin, and as required, the flame retardant, the stabilizer, and the like, and kneading these with a kneading machine.

The above-mentioned kneading machine is particularly not limited, but the method which uses three or two rolls, and by applying a shearing force and repeating the position exchange, disperses the flame retardant particles, and the method which uses a kneader, a Banbury mixer, an intermixer, a one-axis extruder, or a two-axis extruder, and by applying a collision or shearing force of the dispersion wall, disperses the flame retardant particles are preferably used from the viewpoint of providing a high dispersibility.

The kneading temperature varies depending upon the amounts of addition of the matrix resin, the flame retardant particles and the like. However, it is preferably in the range of 50 to 450 deg C, and is more preferably in the range of 60 to 380 deg C.

On the other hand, because the flame retardant particles in the present invention adequately have a coated layer on the surface, they can be uniformly dispersed into the resin not only in the mechanical mixing with the use of the kneader, two-axis extruder, rolls or the like, but also in the solution in which the matrix resin is dissolved or swollen.

In addition, in the polymerization process for manufacturing a resin, the flame retardant particles in the present invention can also be mixed with a polymerization solvent. Thus, that they have a great degree of freedom in dispersion into the resin can be considered to be a factor of that, even if the amount of compounding is small, the flame retardancy is achieved, and thus the mechanical strength is not impaired, which results in the workability being improved. Therefore, the flame retardant particles in the present invention can be applied to various working methods for obtaining of a wide variety of shapes of processed goods, such as pellets, fibers, films, sheets, structures, and the like.

The organic solvent to be used in the polymerization is not particularly limited, and examples include methanol, ethylformamide, nitromethane, ethanol, acrylic acid, acetonitrile, aniline, cyclohexanol, n-butanol, methylamine, n-amylalcohol, acetone, methylethylketone, chloroform, benzene, ethyl acetate, toluene, diethylketone, carbon tetrachloride, benzonitrile, cyclohexane, isobutyl chloride, diethylamine, methylcyclohexane, isoamyl acetate, n-octane, n-heptane, isobutyl acetate, isopropyl acetate, methylisopropylketone, butyl acetate, methylpropylketone, ethylbenzene, xylene, tetrahydrofran, trichloroethylene, methylethylketone, methylene chloride, pyridine, n-hexanol, isopropyl alcohol, dimethylformamide, nitromethane, ethyleneglycol, glycerolformamide, dimethylformamide, dimethylsulfoxide, and the like.

These can be used alone or in combination of two or more with one another.

The mixing temperature in the polymerization is in the range of 0 to 200 deg C, is preferably in the range of room temperature to 150 deg C, and is particularly preferably in the range of 10 to 100 deg C. Depending upon the case, pressure may be applied or may not be applied.

In the flame-retardant resin composition after the kneading or the above-mentioned solution dispersion, the flame retardant particles are preferably dispersed uniformly in the primary particle diameter. This dispersion condition can be simply and easily determined by using UV rays or visible light to measure the permeability for a sheet of the flame-retardant resin composition.

The measuring method is as follows:

10 g of an ethylene-vinyl acetate copolymer (EV260, manufactured by Mitsui DuPont) is dissolved into 100ml of tetrahydrofran. And then, 0.5 g of the flame retardant fine particles is dispersed into the above tetrahydrofran solution. The obtained sample solution is cast onto the glass stage plate, and dried at 60 deg C for 3 hr to manufacture a film 20 μm thick. This film is used as the sample to measure the permeability by using a UV/visible spectrophotometer.

The permeability determined by the above-mentioned measuring method is preferably in the range of 40 to

90%, and is more preferably in the range of 60 to 90% at a wavelength of 550 nm.

Hereinabove, the flame-retardant resin composition of the present invention and the manufacturing method thereof have been briefly described. The flame-retardant resin composition of the present invention is characterized in that, by atomizing the conventional flame retardant, the specific surface area of the particles is increased for increasing the area of contact with the polymer (the matrix resin), and by using the auxiliary flame retardant which is a char-forming compound in combination, a high flame retarding capability is achieved with a small amount of compounding.

In addition, the flame retardant particles in the present invention have a coated layer (an organic compound or a polysilicone) on the surface, which allows them to be more uniformly distributed into the resin, resulting in the flame retarding effect being improved.

Furthermore, the flame-retardant resin composition of the present invention is highly flame retardant with a small amount of addition of the flame retardant particles, thus it is not only excellent in the mechanical properties, but also imposes a low burden on the environment, compared to the conventional halogen-based or phosphoester flame retardant.

And the metal hydrate of the present invention is not deteriorated by thermal history in recycling, thus the flame- retardant resin composition of the present invention is high in recyclability. Further, the flame retardant particles used have a size smaller than the wavelength of the visible light, and are uniformly dispersed when compounded into the resin, thus the flame-retardant resin composition is excellent in transparency.

<Flame-retardant resin molded item>

The flame-retardant resin molded item of the present invention is a composition comprising the flame-retardant resin composition of the present invention that is molded by means of a molding machine.

As the above-mentioned molding machine, one or more molding machines selected from a press molding machine, an injection molding machine, a mold molding machine, a blow molding machine, an extrusion molding machine, and a spinning molding machine can be used. Therefore, molding may be carried out with any one of these, or after molding being carried out with one of these, some other molding machine may be used for successively carrying out the molding.

The molded shape of the flame-retardant resin molded item of the present invention is not particularly limited to the shape of a sheet, the shape of a bar, the shape of a filament, and the like. In addition, the size is also not limited.

The flame-retardant resin molded item of the present invention can be used, for example, for packaging, building and the like as a molded material in the shape of a sheet, and as a cabinet, an internal part, other OA equipment parts and the like for copying machines, printers, and the like.

Hereinbelow, the advantages of the flame-retardant resin molded item of the present invention that are obtained when it is used as each of the following exemplified parts as the above-mentioned OA equipment parts are briefly described.

(Cabinet)

In the present invention, flame retardant particles comprising a metal hydrate are used as a flame retardant, thus in combustion, no poisonous gasses, such as a halogen-based gas, dioxin, cyan, and the like, are produced, with a high flame retardancy being obtained. And, the high flame retardancy, a high modulus of bending elasticity, and a good molding workability allow parts with a thin wall thickness to be molded, as compared to conventional molded items, thus the flame-retardant resin molded item of the present invention is preferable as a structural material of a cabinet. In addition, by containing a surface-treated metal hydrate in the resin composition, the surface resistance of the resin composition can be reduced, which results in the cabinet surface being also excellent in the electrification prevention performance.

With conventional non-halogen-based flame retardant resin compositions, inorganic and organic phosphorouses are used. They are hydrolyzable, thus are influenced by the moisture in the atmosphere, shortening the service life of the resin compositions into which they are compounded. On the other hand, the flame-retardant resin composition of the present invention has a good stability to hydrolysis and heat, thus it has a long service life and is excellent in recyclability, even as compared to the conventional non-halogen-based flame retardant resin composition, which has a phosphorous-based flame retardant compounded. Further, with the flame-retardant resin composition of the present invention, the discoloration (after-yellowing) and reduction in abrasion resistance in service can be suppressed, and the oil resistance is also excellent, thus it is preferable.

(Internal resin molded item)

When the flame-retardant resin composition of the present invention is used as an internal resin molded item,

it is excellent in maintenability of the flame retarding capability, and in dimensional accuracy of the molded item, thus being preferable. In the inside of a piece of OA equipment, the heat generation section for melting and fixing the toner and the like are provided, thus the resin is also required to have a heat resistance. Especially when a piece of OA equipment is to be used in a highly humid region, the resin molded item is required to have a higher heat resistance and a higher hydrolysis resistance. Because the flame retardant particles is resistant to thermal decomposition, the heat resistance maintenability of the resin into which they are mixed is high, when compared to the other flame retardants. With conventional non-halogen-based flame retardant resin compositions, inorganic and organic phosphorouses are used. However, they are hydrolyzable as mentioned above, thus, offering a disadvantage that they shorten the resin compositions into which they are compounded. On the other hand, the flame-retardant resin composition of the present invention is good in heat resistance and hydrolysis resistance, thus it is excellent in dimensional accuracy, as compared to the non-halogen-based flame retardant resin composition, and is suitable for use as an internal resin molded item.

(ROS frame)

When the flame-retardant resin composition of the present invention is used as an ROS frame, it is preferable because of the excellence in dimensional accuracy of the molded item. The reasons why it is excellent in dimensional accuracy are the same as those for the internal resin molded item. In addition, with the flame-retardant resin composition of the present invention, the flame retardant particles have a large specific surface area, thus providing a large surface area of contact with the polymer, and further they are truly spherical, thus the flame-retardant resin composition of the present invention is low in molding anisotropy and thermal shrinkage percentage, allows the mechanical strength to be increased, and is high in flame retardancy.

(Bearing and Gear)

In this application, the flame-retardant resin composition of the present invention is excellent in slidability and dimensional accuracy of the molded item, and thus it is preferable. The reasons why it is excellent in dimensional accuracy are the same as those for the internal resin molded item. In addition, because the flame retardant particles in the present invention are truly spherical, the resin composition into which they are mixed are excellent in slidability, and low in molding anisotropy and thermal shrinkage percentage.

As described above, the flame-retardant resin composition of the present invention is excellent in flame retardancy. Specifically, with the flame-retardant resin composition of the present invention, the heat generation rate as measured with an ISO 5660 cone calorimeter is preferably one third or less, as compared to that for the constitutional resin single unit molded item before comprising the flame retardant particles and the like.

In addition, the flame-retardant resin composition of the present invention has an effect of accelerating the effect of the flame retardancy, but also provides the low smoke emission function which suppresses the formation of soot (a carbide) in combustion. Specifically, with the flame-retardant resin composition of the present invention, the amount of smoke emission as measured with an ISO 5660 cone calorimeter is preferably equivalent to or smaller than that for the constitutional resin single unit molded item before comprising the flame retardant particles and the like. Herein, the word "being equivalent to" refers to being within the range of (1% of the amount of smoke emission for the constitutional resin single unit molded item.

Further, as the recyclability, the flame-retardant resin molded item obtained after repeating the remolding five times under the conditions that the flame-retardant resin molded item having a flammability class of V2 or better on the basis of the UL-94 test is ground, and the grinds are kneaded with a kneading machine, such as a two-axis extruder or the like, for being repelletized, and injection molded with an injection molding machine to provide a resin molded item again preferably has a yield stress of 60% or more of that before remolding, and more preferably has a yield stress of 80% or more. In addition, the flame-retardant resin molded item obtained by remolding in the same manner preferably exhibits the same flame retardancy as that before remolding. After the flame-retardant resin molded item being ground, cleaning for removing the foreign matters may be carried out before kneading. The kneading temperature is the same as that for the previously described flame-retardant resin composition.

## EXAMPLES

Hereinbelow, the present invention is more specifically described with examples. However, the present invention is not limited to the following examples.

First, an example of manufacturing the flame retardant particles used for the present invention is given. In addition, flame-retardant resin compositions using these flame retardant particles are manufactured, and the properties thereof are examined.

(Preparation of flame retardant particles)

The flame retardant particles used in the following examples are described.

200 g of magnesium hydroxide particles (Magnesia 50H, manufactured by Ube Material Industries, Ltd.) having a volume-average particle diameter of 80 nm as the flame retardant particles and 200 g of octamethylcyclotetrasiloxane as a cyclic organosiloxane compound are weighed into a separate glass container, respectively. These and the container are installed in an desiccator which is capable of evacuation and hermetically sealing. Then, by using a vacuum pump, the internal pressure of the desiccator is reduced to 80 mmHg before hermetically sealing the desiccator. Thereafter, the desiccator container with the content is left in a 60 deg C environment for 12 hr before the treatment being carried out. After the treatment, the surface coated flame retardant particles (the flame retardant particles) which are subjected to the surface treatment are taken out from the glass container.

The volume-average particle diameter of the surface-coated flame retardant particles obtained is 80 nm, and the degree of dispersion is 0.5. In addition, the surface-coated flame retardant particles are accurately weighed to calculate the amount of surface coating, which is found to be 30 percent by mass, and also by observation with a transmission electron microscope (TecnaiG2, manufactured by FEI Company), it is verified that the surface-coated flame retardant particles are uniformly coated.

<EXAMPLE 1>

(Manufacture of flame-retardant resin composition and flame-retardant resin molded item)

The surface-coated flame retardant particles, the ABS resin (191, manufactured by Asahi Kasei Corporation), the zinc borate (FLAMEBREAK ZB, manufactured by US Borax Inc.) as the auxiliary flame retardant are weighed by the prescribed amounts as given in Table 1 and mixed, which is followed by kneading with a two-axis extruder, and hot cutting the strand to obtain chips of the flame-retardant resin composition. By molding the obtained chips with a hot press (for heating them at 120 deg C for 10 min), a molded element in the form of a sheet of a thickness of 2 mm (a flame-retardant resin molded item) is obtained.

(Evaluation of flame-retardant resin molded item)

For the molded element in the form of a sheet that is manufactured as described above, the following evaluations are conducted.

- *Flammability testing (UL-94)*

As the flammability test (UL-94), the vertical burning test is carried out in accordance with JIS Z 2391 (Test flames -- 50 W horizontal and vertical flame test methods). The thickness of the sample is 2 mm. For the flammability test accepted items, the level providing the highest flame retarding effect is defined as V0, and the subsequent levels are defined as V1, V2, and HB, respectively, in the order of level. On the other hand, any molded item which do not reach the level HB is evaluated to be a reject.

- *Flammability testing (with cone calorimeter)*

As the flammability test (with cone calorimeter), by use of a cone calorimeter (Corn Calorimeter IIIC3, manufactured by Toyo Seiki Seisaku-Sho, Ltd.), and in conformity with ISO 5660, the relation between the burning time and the heat generation rate is examined with the amount of radiation heat being set at 50 kW/m$^2$, and at the same time the amount of smoke emission is examined.

- *Mechanical strength testing*

As the mechanical strength test, an autograph (V1-C, manufactured by Toyo Seiki Seisaku-Sho, Ltd.) is used, and in conformity with JIS K 7161 (Plastics -- Determination of tensile properties Part 1: General principles), the yield stress is measured at room temperature with the rate of pulling being set at 50 mm/min.

- *Surface resistance value*

The surface resistance value is measured by using a measuring instrument (P-616, manufactured by Kawaguchi Electric Works Co., Ltd.), and in conformity with IEC 60093, a sample is formed, and is held under the conditions of 23

deg C and a humidity of 55% for one day, which is then followed by measuring the surface resistance value.

- *Recyclability*

The molded element in the form of a sheet is ground by use of a small-sized two-axis grinding machine (CSS, manufactured by FUJITEC Co.) to be formed into pellets, which are then extruded by means of an extruder (TEM-SS, manufactured by TOSHIBA MACHINE CO., LTD.) under the conditions of a feed temperature of 180 deg C, a head temperature of 220 deg C, and a screw rotating speed of 60 rpm, then injection molding is carried out by the use of an injection molding machine (J55AD, manufactured by The Japan Steel Works, LTD.) under the conditions of a nozzle temperature of 220 deg C, and a mold temperature of 40 deg C. For a molded item after this remolding is repeated five times, the flammability tests and mechanical strength test are carried out, and the results are compared with the values of the properties before remolding (for the yield stress, the value is given in percentage of that before remolding). The change in appearance (transparency) is also verified by visual inspection.
The results are collectively given in Table 1.

<EXAMPLES 2 to 4 and 6 COMPARATIVE EXAMPLES 1 to 3>

A flame-retardant resin composition is manufactured in the same manner as in EXAMPLE 1, except that, in manufacture of the flame-retardant resin composition in EXAMPLE 1, the types of and the amounts of compounding of the flame-retardant particles, the ABS resin, the flame retardant, and the auxiliary flame retardant are defined as given in Table 1, and evaluated in the same manner as in EXAMPLE 1.
Herein, the ABS resin which is used in EXAMPLE 6 is a polycarbonate modified ABS resin. The polycarbonate modified ABS resin can be manufactured by using a polystyrene into which the polycarbonate structure is introduced, as disclosed, for example, in JP-A No. 2004-331709. Specifically, it is synthesized in the following manner.

(Manufacture of polycarbonate-structure introduced polystyrene)

A stirring bar is placed in a 500-ml glass flask equipped with a cooling tube, and, into the flask, 0.5 g of poly (4-vinylphenol) (manufactured by Aldrich Chemical Company; a weight-average molecular weight: 8000), 18 g of diphenyl carbonate, 25 mg of 4-dimethylaminopyridine are introduced. After substituting nitrogen for the air in the container, the container is placed in an oil bath at 200 deg C to start the reaction. After 5 hr, the content is thrown into methanol to stop the reaction for resettling the polymer. The polymer is recovered by filtration, and cleaned a few times with methanol (the yield is 420 mg). By fractionating the obtained polymer with methylene chloride, 320 mg of a soluble polymer and 100 mg of an insoluble polymer are obtained. The weight-average molecular weight (Mw) and the molecular weight degree of dispersion (Mw/Mn) of the polymer soluble in methylene chloride are 22,500 and 2.1, respectively.
Here are the results of measurement of the nuclear magnetic resonance spectra for the obtained polymer soluble in methylene chloride.

- Nuclear magnetic resonance spectrum ($CDCl_3$, $^1H$, in ppm): (1.2 to 1.5 (b, 2H), 1.5 to 2.0 (b, 1H), 6.2 to 6.7 (b, 2H), 6.7 to 7.2 (b, 2H), 7.3 (b, 3H), 7.4 (b, 4H)
- Nuclear magnetic resonance spectrum ($CDCl_3$, $^{13}C$, in ppm): (40, 42 to 46, 120.4, 120.8, 126, 128.2, 129, 8, 149, 151, 152

(Manufacturing of polycarbonate modified ABS resin)

The polycarbonate modified ABS resin can be obtained by copolymerizing the above-mentioned polycarbonate-structure introduced polystyrene with vinylacrylonitrile and butadiene, or polymer-blending with polyacrylonitrile and polybutadiene. Herein, the latter polymer blending method is used. 30 parts by mass of the polycarbonate-structure introduced polystyrene obtained as mentioned above, 40 parts by mass of polyacrylonitrile (Valex #3000, manufactured by Mitsui Chemicals, Inc.), and 30 parts by mass of polybutadiene (Nipol BR1220, manufactured by ZEON CORPORATION) are kneaded at 220 deg C by using a two-axis extruder (KZW15-45, manufactured by TECHNOVEL CORPORATION) for obtaining the polycarbonate modified ABS resin. Thereafter, a molded element in the form of a sheet of a thickness of 2 mm (a flame-retardant resin molded item) is obtained in the same manner as that in EXAMPLE 1.
The results are given in Table 1.

[Table 1]

| [Table 1] | | EX. 1 | EX. 2 | EX. 3 | EX. 4 | | EX. 6 | | COMP. EX. 1 | COMP. EX. 2 | COMP. EX. 3 |
|---|---|---|---|---|---|---|---|---|---|---|---|
| Flame retardant resin composite | Surf.-coated flame retard. particles (p.) | 25 | 25 | 25 | 25 | | 10 | | | | |
| | Flame retardant particles 1 (parts) | | | | | | | | | | 25 |
| | Flame retardant particles 2 (parts) | | | | | | | | | | |
| | Flame retardant (parts) | | | | | | 15 | | | 100 | |
| | ABS resin (parts) | 100 | 100 | 100 | 100 | | 100*) | | 100 | 100 | 100 |
| | Aux. flame retard. 1 | | | | | | | | | | |
| | Aux. flame retard. 2 | 10 | | | 10 | | | | | | |
| | Aux. flame retard. 3 | | 10 | | 10 | | 10 | | | | |
| | Aux. flame retard. 4 | | | 10 | | | | | | | |
| Total (parts) | | 135 | 135 | 135 | 145 | | 135 | | 100 | 200 | 125 |

*) Polycarbonate modified ABS resin

(Continued on next page)

(Continued from previous page [Table 1])

| | | EX. 1 | EX. 2 | EX. 3 | EX. 4 | | EX. 6 | | COMP. EX. 1 | COMP. EX. 2 | COMP. EX. 3 |
|---|---|---|---|---|---|---|---|---|---|---|---|
| Flame retardancy | Heat generation rate ($kW/m^2$) | 280 | 260 | 290 | 210 | | 190 | | 1580 | 420 | 480 |
| | Amount of smoke emission ($m^2/kg$) | 1010 | 1090 | 1110 | 1010 | | 950 | | 1350 | 1120 | 1080 |
| | UL-94 | V-1 | V-1 | V-1 | V-0 | | V-0 | | HB | V-2 | V-2 |
| Electrical properties | Surface resistance ($\Omega \cdot cm^2$) | 1E+15 | 1E+15 | 1E+15 | 1E+15 | | 1E+15 | | 1E+16 | 1E+16 | 1E+16 |
| Mechanical properties | Yield stress (MPa) | 39 | 38 | 39 | 36 | | 46 | | 46 | 26 | 36 |
| Recycl-ability | Yield stress recovering rate (%) | 78 | 82 | 80 | 81 | | 73 | | 72 | 70 | 68 |
| | Flame retardancy | V-1 | V-1 | V-1 | V-0 | | V-0 | | HB | V-2 | V-2 |
| | Appearance | natural | natural | natural | natural | | natural | | natural | whitened | whitened |

Flame retardant particles 1: Magnesium hydroxide (500H, manufactured by Ube Material Industries, Ltd.; particle dia: 80 nm)

Flame retardant particles 2: Magnesium hydroxide (MGZ-3, manufactured by SAKAI CHEMICAL INDUSTRY CO., LTD.; particle dia: 200 nm)

Flame retardant: Magnesium hydroxide (KISUMA 5A, manufactured by Kyowa Chemical Industry Co., Ltd.; particle dia: 800 nm)

Aux. flame retardant 1: Phosphoester (TPP, manufactured by DAIHACHI CHEMICAL INDUSTRY CO., LTD)

Aux. flame retardant 2: Zinc borate (FLAMEBREAK ZB, manufactured by US Borax Inc.)

Aux. flame retardant 3: Silicone compound (DC4, manufactured by Dow Corning Toray Co., Ltd.)

Aux. flame retardant 4: nitrogen-based aux. flame retardant (Apinon-101, manufactured by Sanwa Chemical Co., Ltd.)

<EXAMPLES 8 to 12 and COMPARATIVE EXAMPLES 4 to 8>

A flame-retardant resin composition is manufactured in the same manner as in EXAMPLE 1, except that, in manufacture of the flame-retardant resin composition in EXAMPLE 1, a polycarbonate resin (HF1110, manufactured by General Electric compay) or polyphenyleneether (Zylon SW201A, manufactured by Asahi Kasei Corporation) is used as a matrix resin in addition to the ABS resin, and the types of and the amounts of compounding of the flame-retardant particles, the flame retardant, and the auxiliary flame retardant are defined as given in Table 2, and evaluated in the same manner as in EXAMPLE 1.

The results are given in Table 2.

**[Table 2]**

| | | EX. 8 | EX. 9 | EX. 10 | EX. 11 | EX. 12 | COMP. EX. 4 | COMP. EX. 5 | COMP. EX. 6 | COMP. EX. 7 | COMP. EX. 8 |
|---|---|---|---|---|---|---|---|---|---|---|---|
| Flame retardant resin composite | Surf.-coated flame retard. particles (p.) | 10 | 10 | 10 | 10 | 10 | | | | | |
| | Flame retardant particles 1 (parts) | | | | | | | | | | |
| | Flame retardant particles 2 (parts) | | | | | | | | | | |
| | Flame retardant (parts) | | | | | | | 50 | 50 | | 50 |
| | ABS resin (parts) | 100 | 100 | 100 | 100 | 100 | 100 | 100 | 100 | 100 | 100 |
| | PC resin (parts) | 30 | 30 | | | | 10 | 10 | 10 | | |
| | PPE resin (parts) | | | 30 | 30 | 30 | | | | 10 | 10 |
| | Aux. flame retard. 1 | | | | | | | | 10 | | |
| | Aux. flame retard. 2 | 10 | | 10 | | | | | | | |
| | Aux. flame retard. 3 | | 10 | | 10 | | | | | | |
| | Aux. flame retard. 4 | | | | | 10 | | | | | |
| Total (parts) | | 150 | 150 | 150 | 150 | 150 | 110 | 160 | 170 | 110 | 160 |

(Continued on next page)

(Continued from previous page[Table 2])

| | | EX. 8 | EX. 9 | EX. 10 | EX. 11 | EX. 12 | COMP. EX. 4 | COMP. EX. 5 | COMP. EX. 6 | COMP. EX. 7 | COMP. EX. 8 |
|---|---|---|---|---|---|---|---|---|---|---|---|
| Flame retardancy | Heat generation rate (kW/m$^2$) | 190 | 210 | 220 | 210 | 230 | 1100 | 450 | 190 | 1030 | 490 |
| | Amount of smoke emission (m$^2$/kg) | 1110 | 1130 | 1100 | 1140 | 1010 | 1310 | 1110 | 1200 | 1390 | 1180 |
| | UL-94 | V-0 | V-0 | V-0 | V-0 | V-0 | HB | V-2 | V-0 | HB | V-2 |
| Electrical properties | Surface resistance (Ω·cm$^2$) | 1E+15 | 1E+15 | 1E+15 | 1E+15 | 1E+15 | 1E+15 | 1E+16 | 1E+16 | 1E+16 | 1E+16 |
| Mechanical properties | Yield stress (MPa) | 41 | 39 | 39 | 40 | 41 | 48 | 33 | 30 | 51 | 34 |
| Recycl-ability | Yield stress recovering rate (%) | 65 | 70 | 68 | 64 | 62 | 65 | 64 | 25 | 67 | 68 |
| | Flame retardancy | V-0 | V-0 | V-0 | V-0 | V-0 | HB | V-2 | reject | HB | V-2 |
| | Appearance | natural | natural | natural | natural | natural | natural | whitened | natural | natural | whitened |

Flame retardant particles 1: Magnesium hydroxide (500H, manufactured by Ube Material Industries, Ltd.; particle dia: 80 nm)

Flame retardant particles 2: Magnesium hydroxide (MGZ-3, manufactured by SAKAI CHEMICAL INDUSTRY CO., LTD.; particle dia: 200 nm)

Flame retardant: Magnesium hydroxide (KISUMA 5A, manufactured by Kyowa Chemical Industry Co., Ltd.; particle dia: 800 nm)

PC resin: HF1110 (manufactured by GE)

PPE resin: Zylon SW201A (manufactured by Asahi Kasei Corporation)

Aux. flame retardant 1: Phosphoester (TPP, manufactured by DAIHACHI CHEMICAL INDUSTRY CO., LTD)

Aux. flame retardant 2: Zinc borate (FLAMEBREAK ZB, manufactured by US Borax Inc.)

Aux. flame retardant 3: Silicone compound (DC4, manufactured by Dow Corning Toray Co., Ltd.)

Aux. flame retardant 4: nitrogen-based aux. flame retardant (Apinon-101, manufactured by Sanwa Chemical Co., Ltd.)

<EXAMPLES 13 to 17 and COMPARATIVE EXAMPLES 9 to 13>

A flame-retardant resin composition is manufactured in the same manner as in EXAMPLE 1, except that, in

manufacture of the flame-retardant resin composition in EXAMPLE 1, polystyrene (HF77, manufactured by PS Japan Corporation) or high-impact polystyrene (400, manufactured by PS Japan Corporation) is used as a matrix resin, and the types of and the amounts of compounding of the flame-retardant particles, the flame retardant, and the auxiliary flame retardant are defined as given in Table 3, and evaluated in the same manner as in EXAMPLE 1.

The results are given in Table 3.

**[Table 3]**

| | | EX. 13 | EX. 14 | EX. 15 | EX. 16 | EX. 17 | COMP. EX. 9 | COMP. EX. 10 | COMP. EX. 11 | COMP. EX. 12 | COMP. EX. 13 |
|---|---|---|---|---|---|---|---|---|---|---|---|
| Flame retardant resin composite | Surf.-coated flame retard. particles (p.) | 25 | 25 | 25 | 25 | 25 | | | | | |
| | Flame retardant particles 1 (parts) | | | | | | | | | | |
| | Flame retardant particles 2 (parts) | | | | | | | | | | |
| | Flame retardant (parts) | | | | | | | 100 | 100 | | 100 |
| | PS resin (parts) | 100 | 100 | 100 | 100 | | 100 | 100 | 100 | | |
| | HIPS resin (parts) | | | | | 100 | | | | 100 | 100 |
| | Aux. flame retard. 1 | | | | | | | | 10 | | 10 |
| | Aux. flame retard. 2 | 10 | | | 10 | 10 | | | | | |
| | Aux. flame retard. 3 | | 10 | | 10 | 10 | | | | | |
| | Aux. flame retard. 4 | | | 10 | | | | | | | |
| Total (parts) | | 135 | 135 | 135 | 145 | 145 | 100 | 200 | 210 | 100 | 210 |

(Continued on next page)

(Continued from previous page [Table 3])

| | | EX. 13 | EX. 14 | EX. 15 | EX. 16 | EX. 17 | COMP. EX. 9 | COMP. EX. 10 | COMP. EX. 11 | COMP. EX. 12 | COMP. EX. 13 |
|---|---|---|---|---|---|---|---|---|---|---|---|
| Flame retardancy | Heat generation rate ($kW/m^2$) | 410 | 390 | 420 | 220 | 210 | 2100 | 450 | 210 | 2300 | 230 |
| | Amount of smoke emission ($m^2/kg$) | 1610 | 1500 | 1540 | 1520 | 1490 | 1560 | 1580 | 1850 | 1610 | 1520 |
| | UL-94 | V-2 | V-2 | V-2 | V-0 | V-0 | reject | V-2 | V-0 | reject | V-0 |
| Electrical properties | Surface resistance ($\Omega \cdot cm^2$) | 1E+15 | 1E+15 | 1E+15 | 1E+15 | 1E+15 | 1E+16 | 1E+16 | 1E+16 | 1E+16 | 1E+16 |
| Mechanical properties | Yield stress (MPa) | 34 | 35 | 33 | 32 | 28 | 45 | 15 | 13 | 31 | 12 |
| Recycl-ability | Yield stress recovering rate (%) | 72 | 68 | 62 | 77 | 81 | 79 | 58 | 13 | 81 | 21 |
| | Flame retardancy | V-2 | V-2 | V-2 | V-0 | V-0 | reject | HB | reject | reject | reject |
| | Appearance | white | white | white | white | white | trans-parent | whitened | whitened | whitened | whitened |

Flame retardant particles 1: Magnesium hydroxide (500H, manufactured by Ube Material Industries, Ltd.; particle dia: 80 nm)

Flame retardant particles 2: Magnesium hydroxide (MGZ-3, manufactured by SAKAI CHEMICAL INDUSTRY CO., LTD.; particle dia: 200 nm)

Flame retardant : Magnesium hydroxide (KISUMA 5A, manufactured by Kyowa Chemical Industry Co., Ltd.; particle dia: 800 nm)

PS resin: HF77 (manufactured by PS Japan Corporation)

HIPS resin: 400 (manufactured by PS Japan Corporation)

Aux. flame retardant 1: Phosphoester (TPP, manufactured by DAIHACHI CHEMICAL INDUSTRY CO., LTD)

Aux. flame retardant 2: Zinc borate (FLAMEBREAK ZB, manufactured by US Borax Inc.)

Aux. flame retardant 3: Silicone compound (DC4, manufactured by Dow Corning Toray Co., Ltd.)

Aux. flame retardant 4: nitrogen-based aux. flame retardant (Apinon-101, manufactured by Sanwa Chemical Co., Ltd.)

From the above results, it has been found that the flame-retardant resin composition of the present invention in which the flame-retardant particles and the auxiliary flame retardants in the present invention are compounded have a high flame retardancy and a low smoke emission, do not deteriorate the mechanical properties, and are excellent in recyclability.

In addition, it has been found that, even when combined with an ordinary flame retardant having a large particle diameter, the flame-retardant resin composition of the present invention has a high flame retardancy, and do not deteriorate the mechanical properties.

## Claims

1. A flame-retardant resin composition comprising at least flame-retardant particles comprising a metal-hydrate and having a volume-average particle diameter in the range of 1 nm to 500 nm, and an auxiliary flame-retardant, which are compounded into a matrix resin, wherein
the flame-retardant particles comprising a metal hydrate are present in the largest amount, as main flame-retardant, and the auxiliary flame-retardant is present in a small amount compared to the main flame-retardant, comprising at least one type selected from the group consisting of a boric acid-based auxiliary flame retardant, a silicone compound, and a nitrogen-based auxiliary flame retardant and wherein a coated layer comprising a polysilicone is formed on the surface of the flame-retardant particles.

2. The flame-retardant resin composition according to claim 1, wherein the metal hydrate comprises Mg and at least one type of metal selected from the group consisting of Ca, Al, Fe, Zn, Ba, Cu, and Ni.

3. The flame-retardant resin composition according to claim 1, wherein the metal hydrate is a hydrate of one type of metal selected from Mg, Ca, Al, Fe, Zn, Ba, Cu, and Ni.

4. The frame-retardant composition according to claim 1, wherein the metal hydrate is magnesium hydroxide.

5. The flame-retardant resin composition according to any one of claim 1 to claim 4, wherein the matrix resin comprises an ABS resin and/or polystyrene.

6. The flame-retardant resin composition according to any one of claim 1 to claim 5, further comprising a flame retardant having a volume-average particle diameter of more than 0.5 $\mu$m and no more than 50 $\mu$m.

7. A flame-retardant resin molded item comprising the flame-retardant resin composition according to any one of claim 1 to claim 6.

8. The flame-retardant resin molded item according to claim 7, wherein the flammability on the basis of the UL-94 test is V2 or better, and when remolded, the yield stress is at least 60% of the yield stress before remolding, and the flammability is the same as that before remolding.

9. The flame-retardant resin molded item according to claim 7, wherein the heat generation rate as measured with an ISO 5660 cone calorimeter is no more than one third of that for an item molded from only the resin without the flame-retardant resin composition.

10. The flame-retardant resin molded item according to claim 7, wherein the amount of smoke emission as measured with an ISO 5660 cone calorimeter is equivalent to or smaller than that for an item molded from only the resin without the flame-retardant resin composition.

11. The flame-retardant resin composition according to any one of claim 1 to claim 6 or the molded item according to any one of claims 8-10, wherein the coated layer comprises a polysilicone and is formed by causing a vaporized organic siloxane to act upon the surface of the metal hydrate particles.

## Patentansprüche

1. Flammhemmende Harzzusammensetzung, die mindestens flammhemmende Partikeln aus einem Metallhydrat mit einem volumengemittelten Partikeldurchmesser im Bereich von 1 nm bis 500 nm und ein zusätzliches Flammschutzmitte als Mischung in einer Matrixharz umfasst, wobei die aus einem Metallhydrat bestehenden, den größten Teil ausmachenden flammhemmenden Partikel als Hauptflammschutzmittel vorliegen und das zusätzliche Flammschutzmittel in einer im Vergleich zu dem Hauptflammschutzmittel kleinen Menge vorliegt und mindestens eine Substanz ausgewählt aus der Gruppe bestehend aus einem zusätzlichen Flammschutzmittel auf Borsäurebasis,

einer Silikonverbindung und einem zusätzlichen Flammschutzmittel auf Stickstoffbasis umfasst, und wobei auf der Oberfläche der flammhemmenden Partikel eine Deckschicht aus einem Polysilikon entsteht.

**2.** Flammhemmende Harzzusammensetzung nach Anspruch 1, bei der das Metallhydrat Mg und mindestens eine Metallart ausgewählt aus der Gruppe bestehend aus Ca, Al, Fe, Zn, Ba, Cu und Ni umfasst.

**3.** Flammhemmende Harzzusammensetzung nach Anspruch 1, bei der das Metallhydrat ein Hydrat einer aus Ca, Al, Fe, Zn, Ba, Cu und Ni ausgewählten Metallart ist.

**4.** Flammhemmende Harzzusammensetzung nach Anspruch 1, bei der das Metallhydrat Magnesiumhydroxid ist.

**5.** Flammhemmende Harzzusammensetzung nach einem der Ansprüche 1 bis 4, bei der das Matrixharz ein ABS-Harz und/oder Polystyrol umfasst.

**6.** Flammhemmende Harzzusammensetzung nach einem der Ansprüche 1 bis 5, die weiterhin ein Flammschutzmittel mit einem volumengemittelten Partikeldurchmesser von mehr als 0,5 $\mu$m und nicht mehr als 50 $\mu$m umfasst.

**7.** Formteil aus flammhemmendem Harz, das die flammhemmende Harzzusammensetzung nach einem der Ansprüche 1 bis 6 umfasst.

**8.** Formteil aus flammhemmendem Harz nach Anspruch 7, bei dem die Entflammbarkeit auf Grundlage des UL-94-Tests V2 oder besser ist und die Reißspannung nach dem Umformen mindestens 60% der Reißspannung vor dem Umformen beträgt und die Entflammbarkeit dieselbe ist wie vor dem Umformen.

**9.** Formteil aus flammhemmendem Harz nach Anspruch 7, bei dem die mittels eines ISO 5660-Cone-Kalorimeters gemessene Wärmentwicklungsrate nicht mehr als ein Drittel der Wärmeentwicklungsrate eines Formteils, das nur aus dem Harz ohne die flammhemmende Harzzusammensetzung besteht, beträgt.

**10.** Formteil aus flammhemmendem Harz nach Anspruch 7, bei dem die mittels eines ISO 5660-Cone-Kalorimeters gemessene Menge des emittierten Rauchs im Vergleich zu einem Formteil, das nur aus dem Harz ohne die flammhemmende Harzzusammensetzung besteht, gleich oder kleiner ist.

**11.** Flammhemmende Harzzusammensetzung nach einem der Ansprüche 1 bis 6 bzw. Formteil nach einem der Ansprüche 8 bis 10, bei denen die Deckschicht ein Polysilikon umfasst und **dadurch** entsteht, dass man ein verdampftes organisches Siloxan auf der Oberfläche der Metallhydratpartikel wirken lässt.

## Revendications

**1.** Composition de résine ignifuge comprenant au moins des particules ignifuges comprenant un hydrate métallique ayant un diamètre de particule moyen en volume dans la gamme de 1 nm à 500 nm, et un produit ignifuge auxiliaire qui sont composés en résine matrice, dans laquelle les particules ignifuges comprenant un hydrate métallique sont présentes en la plus grande quantité en tant que produit ignifuge principal et le produit ignifuge auxiliaire est présent en une petite quantité par rapport au produit ignifuge principal, comprenant au moins un type choisi dans le groupe consistant en un produit ignifuge auxiliaire à base d'acide borique, un composé de silicone et un produit ignifuge auxiliaire à base d'azote, et dans lequel une couche enduite comprenant un polysilicone est formée sur la surface des particules ignifuges.

**2.** Composition de résine ignifuge selon la revendication 1, dans laquelle l'hydrate métallique comprend Mg et au moins un type métallique choisi dans le groupe consistant en Ca, Al, Fe, Zn, Ba, Cu et Ni.

**3.** Composition de résine ignifuge selon la revendication 1, dans laquelle l'hydrate métallique est un hydrate d'un type métallique choisi parmi Mg, Ca, Al, Fe, Zn, Ba, Cu et Ni.

**4.** Composition de résine ignifuge selon la revendication 1, dans laquelle l'hydrate métallique est un hydroxyde de magnésium.

**5.** Composition de résine ignifuge selon l'une quelconque des revendications 1 à 4, dans laquelle la résine matrice

comprend une résine à base d'ABS et/ou un polystyrène.

**6.** Composition de résine ignifuge selon l'une quelconque des revendications 1 à 5, comprenant en outre un ignifuge ayant un diamètre de particule moyen en volume supérieur à 0,5 μm et inférieur à 50 μm.

**7.** Article moulé en résine ignifuge comprenant la composition de résine ignifuge selon l'une quelconque des revendications 1 à 6.

**8.** Article moulé en résine ignifuge selon la revendication 7, dans lequel l'inflammabilité sur la base du test UL-94 est égale à V2 ou mieux, et en cas de nouveau moulage, la contrainte d'écoulement est d'au moins 60 % de la contrainte d'écoulement avant le nouveau moulage, et l'inflammabilité est la même que celle avant le nouveau moulage.

**9.** Article moulé en résine ignifuge selon la revendication 7, dans lequel le débit de génération de chaleur tel que mesuré avec un calorimètre à cône ISO 5660 n'est pas supérieur à un tiers de celui pour un article moulé à partir uniquement de résine sans la composition de résine ignifuge.

**10.** Article moulé en résine ignifuge selon la revendication 7, dans lequel la quantité d'émission de fumée telle que mesurée avec un calorimètre à cône ISO 5660 est équivalente à ou inférieure à celle pour un article moulé à partir de la résine seule sans la composition de résine ignifuge.

**11.** Composition en résine ignifuge selon l'une quelconque des revendications 1 à 6 ou article moulé selon l'une quelconque des revendications 8 à 10, dans laquelle la couche enduite comprend un polysilicone et est formée en provoquant l'action d'un siloxane organique vaporisé sur la surface des particules d'hydrate métallique.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 52302621977 A
- JP 2003253266 A
- JP 571450061982 A
- JP 612687631986 A
- JP 102454561998 A
- JP 2000264935 A
- JP 2000191844 A
- JP 2003517488 A
- JP 2003509523 A
- EP 1528083 A
- US 6831120 B
- DE 19828536 A
- WO 2004074361 A
- US 5532302 A
- US 4983663 A
- JP 2004331709 A